# EUROPÄISCHE PATENTSCHRIFT

(11) **EP 2 737 558 B1**
(45) Veröffentlichungstag und Bekanntmachung des Hinweises auf die Patenterteilung: **04.09.2019**
(21) Anmeldenummer: 12743428.0
(22) Anmeldetag: 25.07.2012
(51) Int. Cl.: H01L 51/52

(54) **OLED/QLED-LEUCHTMODUL MIT GLEICHMÄßIGEM ERSCHEINUNGSBILD**
OLED/QLED LUMINOUS MODULE HAVING A UNIFORM APPEARANCE
MODULE D'ÉCLAIRAGE OLED/QLED À APPARENCE UNIFORME

(30) Priorität: 26.07.2011 DE 102011079797
(43) Veröffentlichungstag der Anmeldung: 04.06.2014
(73) Patentinhaber: Tridonic GmbH & Co KG, 6851 Dornbirn (AT)
(72) Erfinder: AMELUNG, Jörg, 01099 Dresden (DE); ERITT, Michael, 01129 Dresden (DE); KIRCHHOF, Christian, 01099 Dresden (DE); DWORZAK, Matthias, 59555 Lippstadt (DE)
(74) Vertreter: Thun, Clemens
(86) Internationale Anmeldenummer: PCT/EP2012/064595
(87) Internationale Veröffentlichungsnummer: WO 2013/014183

(56) Entgegenhaltungen:
- EP-A2- 1 534 049
- JP-A- 2005 017 738
- JP-A- 2006 156 205
- JP-A- 2010 107 551
- US-A1- 2009 015 901

## Beschreibung

Die Erfindung betrifft ein Leuchtmodul mit einem plattenförmigen, aktiven Element und einem plattenförmigen Trägerelement, das eine Oberfläche aufweist, auf der das aktive Element angeordnet ist, wobei das Trägerelement einen, mit Bezug auf das aktive Element überstehenden Randbereich aufweist.

Aus dem Stand der Technik ist ein derartiges Leuchtmodul in Form eines OLED-Moduls (OLED: organische lichtemittierende Diode) bekannt. Das Leuchtmodul weist ein aktives Element mit zwei Elektroden in Form einer metallischen Kathode und einer Anode und einer, zwischen den Elektroden angeordneten, organischen Schicht auf. Das aktive Element gibt bei Anschluss der Elektroden an eine Stromquelle ein Licht ab. Weiterhin weist das Leuchtmodul ein plattenförmiges Trägerelement in Form einer, als Substrat dienenden Glasplatte auf; das aktive Element ist auf einer Oberfläche des Substrats angeordnet. Dabei weist das Trägerelement bzw. das Substrat mit Bezug auf das aktive Element einen überstehenden Randbereich auf.

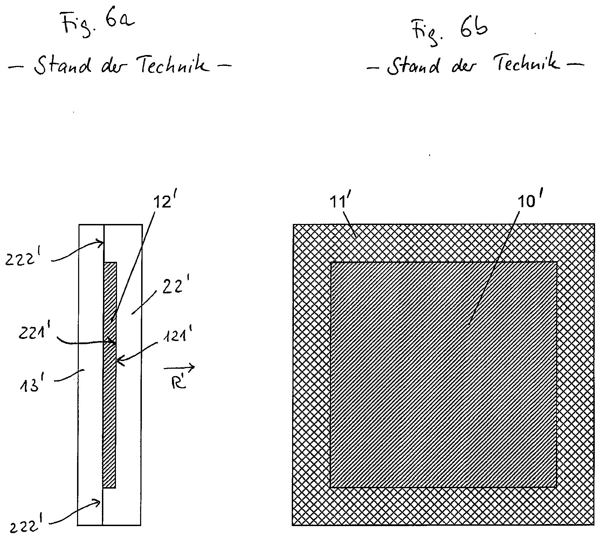

In Fig. 6a ist das bekannte Leuchtmodul im Schnitt skizziert, in Fig. 6b in einer Aufsicht. Das aktive Element 12' ist auf einem Oberflächenbereich 221' des Substrats 22' angeordnet. Auf der dem Substrat 22' gegenüberliegenden Seite des aktiven Elements 12' ist eine Verkapselung 13' angeordnet. Eine Lichtabgabe ist in einer Lichtabstrahlrichtung *R'* vorgesehen, die normal zu einer Oberfläche 121' des aktiven Elements 12' orientiert ist und zwar derart, dass das von dem aktiven Element 12' erzeugte Licht durch das Substrat 22' bzw. die Glasplatte hindurch abgegeben wird. Die in Fig. 6b gezeigte Aufsicht ist eine Aufsicht entgegen der Lichtabstrahlrichtung *R'*. Man erkennt hierbei einen "aktiven Bereich" 10', der bei angelegtem Strom als leuchtender Bereich erscheint. Die Begrenzung des aktiven Bereichs 10' ist dabei durch die reflektierende Metallschicht der Kathode des aktiven Elements 12' festgelegt. Das Substrat 22' weist mit Bezug auf das aktive Element 12' den erwähnten überstehenden Randbereich 222' auf, der - insbesondere auch bei nicht angelegtem Strom bzw. im "ausgeschalteten Zustand" - in der genannten Aufsicht als "passiver Bereich" 11' zu erkennen ist. In dem Randbereich 222' bzw. dem passiven Bereich 11' sind unter anderem Passivierungsschichten, Klebenähte und elektrische Anschlüsse u. s. w. sichtbar bzw. erkennbar. Hierdurch ist das Erscheinungsbild des Leuchtmoduls beeinträchtigt.

Aus der JP 2006-156205 A ist eine Lichtabgabevorrichtung mit plattenförmigen, Licht aussendenden Elementen bekannt, die auf einem plattenförmigen Trägerelement angeordnet sind. Dabei ist ein Randbereich von einem reflektierenden Rahmenelement abgedeckt.

Aus der JP 2005-17738 A ist eine Anzeigevorrichtung mit einer Linsen-artigen Abdeckung bekannt. Weitere Leuchtmodule mit plattenförmigen aktiven Elementen sind aus den Schriften EP 1 534 049 A2 und JP 2010-107551 A bekannt.

Aus der US 2009015901 A1 ist eine Anzeigevorrichtung mit einem Anzeigebereich bekannt, der eine elektrooptische Schicht, eine Licht reflektierende Schicht und einen Rahmenbereich aufweist, wobei von der elektrooptischen Schicht emittiertes Licht zur Betrachtungsseite der Anzeigevorrichtung reflektiert und die lichtreflektierende Schicht in dem Anzeigebereich angeordnet ist. Eine Antireflexplatte verhindert, dass externes Licht, das in die Betrachtungsseite der Anzeigevorrichtung eintritt und von der reflektierenden Schicht oder dem Rahmenbereich reflektiert wird, auf der Betrachtungsseite austritt.

Der Erfindung liegt die Aufgabe zugrunde, ein entsprechend verbessertes Leuchtmodul anzugeben. Insbesondere soll das Leuchtmodul ein verbessertes Erscheinungsbild aufweisen können.

Diese Aufgabe wird gemäß der Erfindung mit den in den unabhängigen Ansprüchen genannten Gegenständen gelöst. Besondere Ausführungsarten der Erfindung sind in den abhängigen Ansprüchen angegeben.

Gemäß der Erfindung ist ein Leuchtmodul vorgesehen, das ein plattenförmiges, aktives Element aufweist, sowie ein plattenförmiges Trägerelement; das Trägerelement weist eine Oberfläche auf, auf der das aktive Element angeordnet ist, wobei das Trägerelement einen, mit Bezug auf das aktive Element überstehenden Randbereich aufweist. Weiterhin weist das Leuchtmodul eine den Randbereich überdeckende Blende auf.

Durch die Blende lässt sich bewirken, dass bei einer Aufsicht auf das Leuchtmodul der überstehende Randbereich weniger deutlich erkennbar ist. Insbesondere lässt sich bewirken, dass dieser Bereich, hier auch im oben genannten Sinn als "passiver Bereich" bezeichnet, besonders homogen erscheint, so dass Bauteile des Leuchtmoduls weniger oder gar nicht hervortreten bzw. erkennbar sind. Insbesondere lässt sich auch erzielen, dass sich das Erscheinungsbild des passiven Bereichs besonders gut an dasjenige des aktiven Elements, hier auch im oben genannten Sinn als "aktiver Bereich" bezeichnet - bei nicht angelegtem Strom bzw. im ausgeschalteten Zustand - anpassen lässt. Hierdurch lässt sich ein besonders homogenes und somit verbessertes Erscheinungsbild des Leuchtmoduls erzielen.

Vorzugsweise ist das Trägerelement aus einem lichtdurchlässigen Material ausgebildet, wobei die Blende auf der dem aktiven Element abgewandten Seite des Trägerelements angeordnet ist.

Erfindungsgemäß ist - in Lichtabstrahlrichtung gesehen - oberhalb bzw. nach der Blende ein flächiges Lichtauskoppelelement angeordnet, welches das aktive Element und die Blende gemeinsam überspannt. Hierdurch lässt sich eine weitergehend verbesserte Anpassung des Erscheinungsbilds des Randbereichs bzw. des passiven Bereichs an das Erscheinungsbild des aktiven Bereichs - bei nicht angelegtem Stromerzielen. Die Blende ist dabei als Folie ausgestaltet oder auf dem Lichtauskoppelelement aufgedruckt und/oder aufgedampft und/oder gesputtert.

Die Erfindung ist dadurch gekennzeichnet, dass das Lichtauskoppelelement eine Mikrostruktur in Form einer Mikroprismen- oder Mikrolinsenstruktur aufweist.

Vorteilhaft ist zwischen der Blende und dem Lichtauskoppelelement ein transparentes Abstandselement, insbesondere eine Glasscheibe angeordnet. Hierdurch lässt sich eine weitergehend verbesserte Vergleichmäßigung des Erscheinungsbilds erzielen. Durch das Abstandselement ist (längs der Lichtabstrahlrichtung) ein Abstand zwischen dem Lichtauskoppelelement und der Blende bewirkt, durch den der Übergang zwischen dem aktiven Bereich und dem passiven Bereich sozusagen zusätzlich verwischt wird.

Vorteilhaft ist die Blende an das Erscheinungsbild des aktiven Elements bzw. des aktiven Bereichs im ausgeschalteten Zustand angepasst, insbesondere kann sie eine dem aktiven Element im Wesentlichen entsprechende Farbe aufweisen. Hierdurch ist eine weitergehend verbesserte Anpassung bzw. Homogenisierung ermöglicht.

Vorteilhaft ist die Blende als reflektierende Schicht ausgebildet. Dabei ist weiterhin vorteilhaft - in Lichtabstrahlrichtung gesehen - oberhalb bzw. nach der Blende eine zirkular polarisierende Folie angeordnet, an deren der Blende zugewandten Seite eine Lambda-Viertel-Verzögerungsschicht angeordnet ist. Hierdurch lässt sich bewirken, dass ein von außerhalb einfallendes Licht, also "Umgebungslicht" zirkular polarisiert wird, bevor es auf die reflektierende Oberfläche der Kathode bzw. des aktiven Elements oder der Blende trifft. Der Phasensprung während der Reflexion dreht bzw. wechselt die Drehrichtung der zirkularen Polarisation und das so reflektierte Licht wird von der polarisierenden Folie nicht mehr nach außen durchgelassen. Im ausgeschalteten Zustand erscheint daher die gesamte betrachtete Oberfläche des Leuchtmoduls bzw. der aktive Bereich und der passive Bereich einheitlich schwarz. Hierdurch ist somit ein besonders homogenes Erscheinungsbild des Leuchtmoduls ermöglicht. Dabei lässt sich erzielen, dass im eingeschalteten Zustand bzw. bei angelegtem Strom noch ca. 50% des vom aktiven Element erzeugten Lichts das Leuchtmodul nach außen verlassen kann.

Dabei ist weiterhin vorteilhaft zwischen der Blende und der zirkular polarisierenden Folie ein transparentes Abstandselement, insbesondere eine Glasscheibe angeordnet. Hierdurch lässt sich wiederum der Übergang zwischen dem aktiven und dem passiven Bereich "vergleichmäßigen".

Gemäß einem weiteren Aspekt der Erfindung ist ein Leuchtmodul vorgesehen, das ein plattenförmiges, aktives Element aufweist, sowie ein plattenförmiges Trägerelement, mit einer Oberfläche, auf der das aktive Element angeordnet ist, wobei das Trägerelement einen, mit Bezug auf das aktive Element überstehenden Randbereich aufweist. Weiterhin weist das Leuchtmodul ein, das aktive Element sowie den Randbereich gemeinsam überdeckendes Vergleichmäßigungselement auf. Durch das Vergleichmäßigungselement lässt sich erzielen, dass bei Blick auf das Leuchtmodul entgegen der Lichtabstrahlrichtung der aktive Bereich und der passive Bereich besonders ähnlich aussehen, also besonders gleichmäßig. Hierdurch lässt sich das Erscheinungsbild des Leuchtmoduls verbessern.

Erfindungsgemäß handelt es sich bei dem Vergleichmäßigungselement um eine reflektierende Polarisationsfolie. Hierdurch lässt sich erzielen, dass das von außen einfallende Licht an dem Vergleichmäßigungselement reflektiert wird und auf diese Weise darunter liegende Strukturen das aktiven und des passiven Bereichs im ausgeschalteten Zustand kaum noch bzw. praktisch nicht mehr sichtbar sind. Im eingeschalteten Zustand lässt die Polarisationsfolie einen großen Anteil des vom aktiven Element erzeugten Lichts passieren, so dass trotz des Vergleichmäßigungselements ein guter Wirkungsgrad des Leuchtmoduls erzielt werden kann.

Vorzugsweise ist dabei das Trägerelement lichtdurchlässig, wobei zwischen dem Trägerelement und dem Vergleichmäßigungselement ein Auskoppelelement, welches vorzugsweise eine Mikrostruktur, insbesondere eine Mikroprismenstruktur aufweist, angeordnet ist.

Dabei ist weiterhin erfindungsgemäß - in Lichtabstrahlrichtung gesehen - an der Oberseite des Vergleichmäßigungselements bzw. nach dem Vergleichmäßigungselement ein weiteres optisches Element in Form einer Lichtstreu- oder Mikrooptikfolie angeordnet. Auf diese Weise lässt sich bewirken, dass durch das weitere optische Element bzw. die Lichtstreu- oder Mikrooptikfolie das von außen einfallende Licht sowohl vor, als auch nach der Reflexion durch die reflektierende Polarisationsfolie gestreut wird. Dadurch lässt sich ein besonders gleichmäßiges, weißes bzw. weißliches Erscheinungsbild für die gesamte Fläche, also den aktiven und den passiven Bereich, erzielen.

Vorzugsweise ist das aktive Element durch eine OLED-Struktur oder durch eine QLED-Struktur (QLED: quantum dots light emitting diode) gebildet.

Die Erfindung wird im Folgenden anhand von Ausführungsbeispielen und mit Bezug auf die Zeichnungen näher erläutert. Es zeigen:
- Fig. 1a: eine skizzierte Schnittdarstellung eines ersten Ausführungsbeispiels eines erfindungsgemäßen Leuchtmoduls,
- Fig. 1b: eine entsprechende Skizze einer Aufsicht,
- Fig. 2a: eine skizzierte Schnittdarstellung eines zweiten Ausführungsbeispiels eines erfindungsgemäßen Leuchtmoduls,
- Fig. 2b: eine entsprechende Skizze einer Aufsicht,
- Fig. 3: eine skizzierte Schnittdarstellung eines dritten Ausführungsbeispiels eines erfindungsgemäßen Leuchtmoduls,
- Fig. 4: eine skizzierte Schnittdarstellung eines vierten Leuchtmoduls,

- Fig. 5: eine skizzierte Schnittdarstellung eines fünften Ausführungsbeispiels eines erfindungsgemäßen Leuchtmoduls,
- Fig. 6a: eine skizzierte Schnittdarstellung eines bekannten Leuchtmoduls und
- Fig. 6b: eine entsprechende Skizze einer Aufsicht.

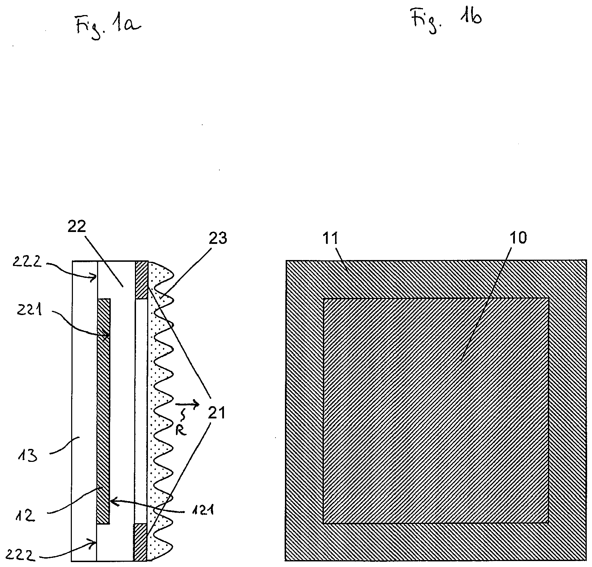

In Fig. 1a ist im Schnitt ein erstes Ausführungsbeispiel eines erfindungsgemäßen Leuchtmoduls skizziert; Fig. 1b zeigt eine entsprechende Aufsicht. Das Leuchtmodul weist ein plattenförmiges, aktives Element 12 auf, sowie ein plattenförmiges Trägerelement 22.

Das Leuchtmodul kann als flächiger Leuchtkörper bzw. als Leuchte dienen bzw. ausgebildet sein. Das aktive Element 12 kann in diesem Sinne eine entsprechende Größe aufweisen, beispielsweise eine Fläche von ca. 5 cm auf 5 cm bilden. Das Leuchtmodul kann auch zur Realisierung einer Leuchte dienen, die insgesamt mehrere entsprechende Leuchtmodule aufweist, die derart angeordnet sind, dass sie zusammen eine große Lichtabgabefläche der Leuchte bilden. Insbesondere in einem derartigen Fall ist es in aller Regel erwünscht, dass das äußere Erscheinungsbild des Leuchtmoduls möglichst homogen ist.

Das aktive Element 12 kann zwei Elektroden in Form einer metallischen Kathode und einer Anode umfassen, sowie eine zwischen den beiden Elektroden angeordnete organische Schicht, die bei Anlegen eines Stroms an die beiden Elektroden ein Licht abgibt. Insbesondere kann das aktive Element 12 eine OLED umfassen oder aus einer solchen bestehen. Alternativ kann das aktive Element 12 eine QLED (QLED: quantum dots light emitting diode) umfassen oder aus einer solchen bestehen.

Das Trägerelement 22 kann ein Substrat sein, insbesondere eine Glasplatte. Auf der dem Substrat bzw. dem Trägerelement 22 gegenüberliegenden Seite des aktiven Elements 12 kann eine Verkapselung 13 angeordnet sein.

Das Trägerelement 22 weist eine Oberfläche 221 auf, auf der das aktive Element 12 angeordnet ist. Es kann vorgesehen sein, dass das Leuchtmodul das von dem aktiven Element 12 erzeugte Licht durch das Trägerelement 22 hindurch abgibt, so dass eine Lichtabstrahlrichtung *R* des Leuchtmoduls gegeben ist, die normal zu einer Oberfläche 121 des aktiven Elements 12 orientiert ist.

In Fig. 1b ist eine Aufsicht auf das Leuchtmodul entgegen der Lichtabstrahlrichtung R skizziert. Man erkennt einen "aktiven Bereich" 10, der bei angelegtem Strom aufgrund des von dem aktiven Element 12 erzeugten Lichts als leuchtender Bereich erscheint. Die Begrenzung des aktiven Bereichs 10 kann dabei insbesondere durch die reflektierende Metallschicht der Kathode des aktiven Elements 12 festgelegt sein.

Das Substrat bzw. das Trägerelement 22 weist mit Bezug auf das aktive Element 12 einen überstehenden Randbereich 222 auf, der bei nicht angelegtem Strom in der genannten Aufsicht als "passiver Bereich" 11 zu erkennen ist.

Weiterhin weist das Leuchtmodul eine, den Randbereich überdeckende Blende 21 auf. Durch diese Blende 21 lässt sich erzielen, dass der überstehende Randbereich 222 in der genannten Aufsicht besonders wenig auffällt bzw. als solcher erkennbar ist. Hierdurch lässt sich das Erscheinungsbild des Leuchtmoduls besonders homogen gestalten.

Bei der Blende 21 kann es sich um ein Abdeckelement handeln, das derart angeordnet ist, dass es in einer Projektion entgegen der Lichtabstrahlrichtung R den überstehenden Randbereich 222 abdeckt, vorzugsweise vollständig abdeckt. Vorteilhaft ist die Blende 21 bzw. das Abdeckelement dabei derart gestaltet, dass es in der genannten Projektion das aktive Element 12 nicht abdeckt, insbesondere zumindest im Wesentlichen auch nicht teilweise abdeckt.

Durch die Blende 21 lässt sich insbesondere der passive Bereich 11 mit Bezug auf eine Oberflächenstruktur und/oder eine Farbe an den aktiven Bereich 10 - bei nicht angelegtem Strom - anpassen. Die Blende 21 kann in diesem Sinne derart ausgebildet sein, dass sie das Erscheinungsbild des aktiven Bereichs 10 "simuliert". Hierdurch lässt sich erzielen, dass der Randbereich 222 bzw. der passive Bereich 11 ein Erscheinungsbild erhält, das zumindest nahezu identisch ist zu dem Erscheinungsbild des aktiven Bereichs 10.

Die Blende 21 kann vorteilhaft als Folie ausgestaltet sein, die vorzugsweise unmittelbar auf dem Trägerelement 22 aufgebracht bzw. angeordnet ist.

Vorteilhaft ist das Trägerelement 22 aus einem lichtdurchlässigen Material, beispielsweise Glas, ausgebildet. Die Blende 21 ist dabei - wie beispielhaft in Fig. 1a skizziert - vorzugsweise auf der, dem aktiven Element 12 abgewandten Seite des Trägerelements 22 angeordnet. Dies trägt bereits an sich zu einer Vergleichmäßigung des Erscheinungsbilds bei.

Eine weitergehend verbesserte Angleichung des Erscheinungsbilds des passiven Bereichs 11 an das Erscheinungsbild des aktiven Bereichs 12 bei nicht abgelegtem Strom lässt sich erzielen, indem - in Lichtabstrahlrichtung *R* gesehen - oberhalb bzw. nach der Blende 21 ein flächiges Lichtauskoppelelement 23 angeordnet ist, welches das aktive Element 12 und die Blende 21 gemeinsam überspannt. Entgegen der Lichtabstrahlrichtung R betrachtet ist in diesem Fall das Lichtauskoppelelement 23 also vor der Blende 21 angeordnet. Das Lichtauskoppelelement 23 kann in der genannten Projektion betrachtet dieselben Begrenzungen aufweisen wie das Trägerelement 22. Das Lichtauskoppelelement 23 kann insbesondere eine Licht streuende Wirkung aufweisen.

Die Blende 21 kann dabei auf dem Lichtauskoppelelement 23 angeordnet sein, beispielsweise auf dem Lichtauskoppelelement 23 aufgedruckt und/oder aufgedampft und/oder gesputtert sein. Wie in Fig. 1a angedeutet, kann die Blende 21 also dementsprechend zwischen dem Trägerelement 22 und dem Lichtauskoppelelement 23 angeordnet sein.

Bei dem Lichtauskoppelelement 23 handelt es sich um eine Auskoppeloptik. Das Lichtauskoppelelement 23 weist eine Mikrostruktur in Form einer Mikroprismen- oder Mikrolinsenstruktur auf.

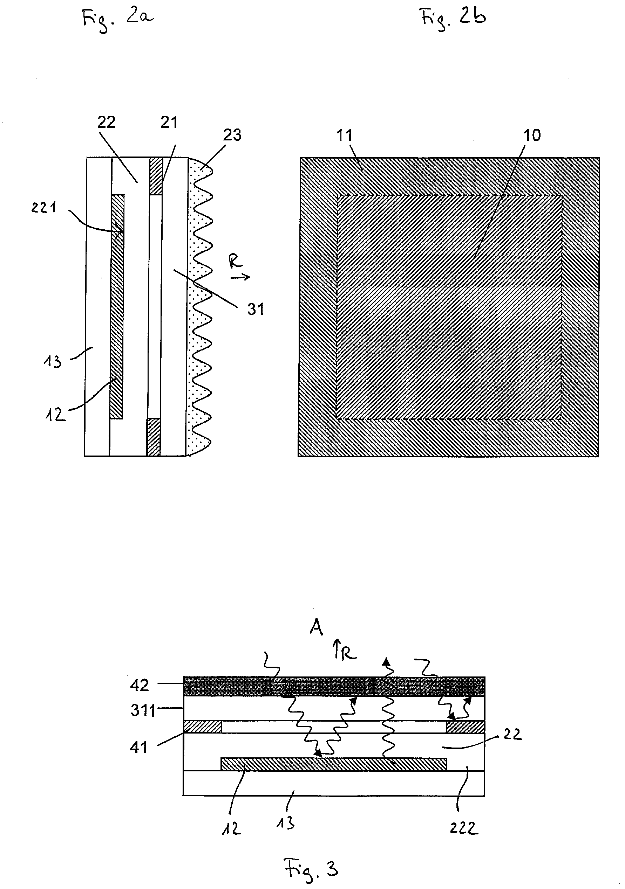

In den Figuren 2a und 2b ist ein zweites Ausführungsbeispiel entsprechend skizziert. Im Folgenden wird lediglich auf die Unterschiede zum ersten Ausführungsbeispiel eingegangen. Die Bezugszeichen sind in analoger Weise gebraucht. Analoges gilt auch für die weiteren Ausführungsbeispiele.

Wie aus Fig. 2a beispielhaft hervorgeht, kann zwischen der Blende 21 und dem Lichtauskoppelelement 23 ein transparentes Abstandselement 31, insbesondere in Form einer Glasscheibe, angeordnet sein.

Durch das Abstandselement 31 wird ein Abstand zwischen dem Lichtauskoppelelement 23 und der Blende 21 gewährleistet; durch diesen Abstand lässt sich bewirken, dass in der genannten Aufsicht der Übergang zwischen dem aktiven Bereich 10 und dem passiven Bereich 11 weniger deutlich erkennbar wird, sozusagen "verwischt" wird.

Die Blende 21 ist vorteilhaft auf dem Lichtauskoppelelement 23 als farblich angepasste Schicht aufgetragen.

In Fig. 3 ist ein drittes Ausführungsbeispiel skizziert. Hierbei ist die Blende 41 als reflektierende Schicht ausgebildet. Dabei ist weiterhin vorteilhaft - in Lichtabstrahlrichtung R gesehen - oberhalb bzw. nach der Blende 41 eine zirkular polarisierende Folie 42 angeordnet, an deren, der Blende 41 zugewandten Seite eine Lambda-Viertel-Verzögerungsschicht angeordnet ist. An der polarisierenden Folie 42 wird von einem Außenraum A bzw. von außerhalb einfallendes Licht zirkular polarisiert, anschließend wird es an der reflektierenden Oberfläche der Kathode bzw. des aktiven Elements 12 oder der Blende 41 reflektiert; dabei erfährt es einen Phasensprung, durch den die Drehrichtung der zirkularen Polarisation geändert wird. Das reflektierte Licht wird somit von der polarisierenden Folie 42 nicht mehr nach außen durchgelassen. Im ausgeschalteten Zustand erscheint daher die gesamte betrachtete Oberfläche des Leuchtmoduls bzw. der aktive Bereich 10 und der passive Bereich 11 einheitlich schwarz.

Weiterhin vorteilhaft ist hierbei zwischen der Blende 41 und der zirkular polarisierenden Folie 42 ein transparentes Abstandselement 311, insbesondere eine Glasplatte angeordnet. Das Abstandselement 311 überdeckt dementsprechend vorzugsweise in einer Projektion entgegen der Lichtabstrahlrichtung R betrachtet das gesamte Trägerelement 22, also sowohl den aktiven Bereich 10, als auch den passiven Bereich 11. Hierdurch lässt sich wiederum eine weitergehende Homogenisierung, insbesondere im Übergangsbereich zwischen dem passiven Bereich 11 und dem aktiven Bereich 10 erzielen.

Die Blende 41 kann wiederum als insbesondere farblich angepasste, auf dem Abstandselement 311 aufgetragene Schicht ausgebildet sein.

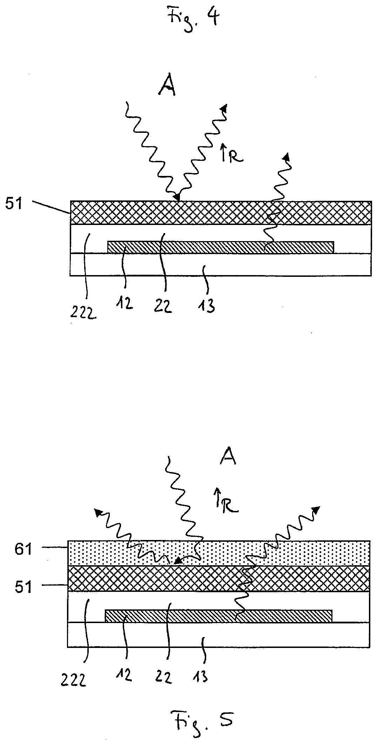

In Fig. 4 ist ein viertes Beispiel skizziert, das keinen Teil der beanspruchten Erfindung bildet. Bei diesem weist das Leuchtmodul ein, das aktive Element 12 sowie den Randbereich 222 gemeinsam überdeckendes Vergleichmäßigungselement 51 auf. Durch Letzteres lässt sich erzielen, dass bei Blick auf das Leuchtmodul entgegen der Lichtabstrahlrichtung R der aktive Bereich 10 bzw. das aktive Element 12 (im ausgeschalteten Zustand) und der passive Bereich 11 bzw. der Randbereich 222 besonders ähnlich aussehen, also besonders gleichmäßig.

Erfindungsgemäss handelt es sich dabei bei dem Vergleichmäßigungselement 51 um eine reflektierende Polarisationsfolie. Hierdurch lässt sich erzielen, dass das vom Außenbereich A einfallende Licht an dem Vergleichmäßigungselement 51 reflektiert wird und auf diese Weise darunter liegende Strukturen das aktiven Bereichs 10 und des passiven Bereichs 11 im ausgeschalteten Zustand kaum noch bzw. praktisch nicht mehr sichtbar sind.

Im eingeschalteten Zustand lässt die Polarisationsfolie einen großen Anteil des vom aktiven Element 12 erzeugten Lichts passieren, so dass trotz des Vergleichmäßigungselements 51 ein guter Wirkungsgrad des Leuchtmoduls erzielt werden kann.

Vorzugsweise ist dabei das Trägerelement 22 lichtdurchlässig, wobei zwischen dem Trägerelement 22 und dem Vergleichmäßigungselement 51 ein (in Fig. 4 nicht gezeigtes) Auskoppelelement, welches vorzugsweise eine Mikrostruktur, insbesondere eine Mikroprismen- oder Mikrolinsenstruktur aufweist, angeordnet ist. Das Auskoppelelement kann dabei analog zu dem in Fig. 2 gezeigten Lichtauskoppelelement 23 gestaltet sein.

In Fig. 5 ist ein fünftes, erfindungsemässes Ausführungsbeispiel skizziert, das eine Erweiterung bzw. Variation des vierten Beispiels darstellt. Gemäß dieser Ausführung ist - in Lichtabstrahlrichtung R gesehen - an der Oberseite des Vergleichmäßigungselements 51 bzw. nach dem Vergleichmäßigungselement 51 ein weiteres optisches Element 61, insbesondere eine Lichtstreu- oder Mikrooptikfolie angeordnet. Durch Letztere lässt sich bewirken, dass das vom Außenraum *A* einfallende Licht sowohl vor, als auch nach der Reflexion durch die reflektierende Polarisationsfolie 51 gestreut wird. Dadurch lässt sich ein gleichmäßig weißliches Erscheinungsbild für die gesamte Fläche, also den aktiven Bereich 10 und den passiven Bereich 11, erzielen.

## Patentansprüche

1. Leuchtmodul, aufweisend
ein plattenförmiges, aktives Element (12),
ein plattenförmiges Trägerelement (22), mit einer Oberfläche (221), auf der das aktive Element (12) angeordnet ist, wobei das Trägerelement (22) einen, mit Bezug auf das aktive Element (12) überstehenden Randbereich (222) aufweist,
wobei das Leuchtmodul eine den Randbereich (222) überdeckende Blende (21, 41) aufweist,
wobei - in Lichtabstrahlrichtung (*R*) gesehen - oberhalb der Blende (21, 41) ein flächiges Lichtauskoppelelement (23) angeordnet ist, welches das aktive Element (12) und die Blende (21) gemeinsam überspannt,
und die Blende (21) als Folie ausgestaltet ist oder auf dem Lichtauskoppelelement (23) aufgedruckt und/oder aufgedampft und/oder gesputtert ist,
**dadurch gekennzeichnet,**
**dass** das Lichtauskoppelelement (23) eine Mikrostruktur in Form einer Mikroprismen- oder Mikrolinsenstruktur aufweist.

2. Leuchtmodul nach Anspruch 1,
**dadurch gekennzeichnet,**
**dass** das Trägerelement (22) aus einem lichtdurchlässigen Material ausgebildet ist und die Blende (21, 41) auf der dem aktiven Element (12) abgewandten Seite des Trägerelements (22) angeordnet ist.

3. Leuchtmodul nach einem der vorhergehenden Ansprüche,
**dadurch gekennzeichnet,**
**dass** zwischen der Blende (21, 41) und dem Lichtauskoppelelement (23) ein transparentes Abstandselement (31), insbesondere eine Glasscheibe angeordnet ist.

4. Leuchtmodul nach einem der vorhergehenden Ansprüche,
**dadurch gekennzeichnet,**
**dass** die Blende (21, 41) an das Erscheinungsbild des aktiven Elements (12) im ausgeschalteten Zustand angepasst ist, insbesondere eine dem aktiven Element (12) im Wesentlichen entsprechende Farbe aufweist.

5. Leuchtmodul nach einem der vorhergehenden Ansprüche,
**dadurch gekennzeichnet,**
**dass** die Blende (41) als reflektierende Schicht ausgebildet ist.

6. Leuchtmodul nach Anspruch 5,
**dadurch gekennzeichnet,**
**dass** - in Lichtabstrahlrichtung (R) gesehen - oberhalb der Blende (41) eine zirkular polarisierende Folie (42) angeordnet ist, an deren der Blende (41) zugewandten Seite eine Lambda-Viertel-Verzögerungsschicht angeordnet ist.

7. Leuchtmodul nach Anspruch 6,
**dadurch gekennzeichnet,**
**dass** zwischen der Blende (41) und der zirkular polarisierenden Folie (42) ein transparentes Abstandselement (311), insbesondere eine Glasscheibe angeordnet ist.

8. Leuchtmodul, aufweisend
ein plattenförmiges, aktives Element (12),
ein plattenförmiges Trägerelement (22), mit einer Oberfläche (221), auf der das aktive Element (12) angeordnet ist, wobei das Trägerelement (22) einen, mit Bezug auf das aktive Element (12) überstehenden Randbereich (222) aufweist,
wobei das Leuchtmodul ein das aktive Element (12) sowie den Randbereich (222) gemeinsam überdeckendes Vergleichmäßigungselement (51) aufweist,
**dadurch gekennzeichnet,**
**dass** das Vergleichmäßigungselement (51) durch eine reflektierende Polarisationsfolie gebildet ist,
wobei - in Lichtabstrahlrichtung (*R*) gesehen - an der Oberseite des Vergleichmäßigungselements (51) eine Lichtstreu- oder Mikrooptikfolie angeordnet ist.

9. Leuchtmodul nach Anspruch 8,
**dadurch gekennzeichnet,**
**dass** das Trägerelement (22) lichtdurchlässig ist und zwischen dem Trägerelement (22) und dem Vergleichmäßigungselement (51) ein Auskoppelelement, welches vorzugsweise eine Mikrostruktur, insbesondere eine Mikroprismenstruktur aufweist, angeordnet ist.

10. Leuchtmodul nach einem der vorhergehenden Ansprüche,
**dadurch gekennzeichnet,**
**dass** das aktive Element (12) durch eine OLED- oder QLED-Struktur gebildet ist.

## Claims

1. Lighting module, comprising
a plate-shaped active element (12),
a plate-shaped carrier element (22) having a surface (221) on which the active element (12) is disposed, wherein the carrier element (22) comprises an edge region (222) which protrudes with respect to the active element (12),
wherein the lighting module comprises a screen (21, 41) which covers the edge region (222),
wherein, viewed in light emission direction (R), a planar light decoupling element (23), which jointly spans the active element (12) and the screen (21), is disposed above the screen (21, 41), and the screen (21) is configured as a film or
is printed and/or vapor-deposited and/or sputtered onto the light decoupling element (23),
**characterized in that**
the light decoupling element (23) comprises a microstructure in the form of a microprism or a microlens structure.

2. Lighting module according to Claim 1,
**characterized in that**
the carrier element (22) is made of a light-transmissive material and the screen (21, 41) is disposed on the side of the carrier element (22) facing away from the active element (12).

3. Lighting module according to any one of the preceding Claims,
**characterized in that**
a transparent spacer element (31), in particular a sheet of glass, is disposed between the screen (21, 41) and the light decoupling element (23).

4. Lighting module according to any one of the preceding Claims,
**characterized in that**
the screen (21, 41) is adapted to the appearance of the active element (12) in the switched-off state, in particular has a color that substantially corresponds to the active element (12).

5. Lighting module according to any one of the preceding Claims,
**characterized in that**
the screen (41) is designed as a reflective layer.

6. Lighting module according to Claim 5,
**characterized in that**,
viewed in light emission direction (R), a circular polarizing film (42) is disposed above the screen (41), on the side of which facing the screen (41), a lambda quarter wave retardation layer is disposed.

7. Lighting module according to Claim 6,
**characterized in that**
a transparent spacer element (311), in particular a sheet of glass, is disposed between the screen (41) and the circular polarizing film (42).

8. Lighting module, comprising
a plate-shaped active element (12),
a plate-shaped carrier element (22) having a surface (221) on which the active element (12) is disposed, wherein the carrier element (22) comprises an edge region (222) which protrudes with respect to the active element (12),
wherein the lighting module comprises
an equalizing element (51), which jointly covers both the active element (12) and the edge region (222),
**characterized in that**
the equalizing element (51) is formed by a reflective polarizing film,
wherein, viewed in light emission direction (R), a light-diffusing or micro-optic film is disposed on the upper side of the equalizing element (51).

9. Lighting module according to Claim 8,
**characterized in that**
the carrier element (22) is light-transmissive and a decoupling element, which preferably comprises a microstructure, in particular a microprism structure, is disposed between the carrier element (22) and the equalizing element (51).

10. Lighting module according to any one of the preceding Claims,
**characterized in that**
the active element (12) is formed by an OLED or QLED structure.

## Revendications

1. Module d'éclairage, comprenant
un élément actif (12) en forme de plaque,
un élément de support (22) en forme de plaque, comprenant une surface (221) sur laquelle est disposé l'élément actif (12), l'élément de support (22) comprenant une zone de bordure (222) en saillie par rapport à l'élément actif (12),
le module d'éclairage comprenant un diaphragme (21, 41) couvrant la zone de bordure (222),
un élément de découplage de lumière (23) plat, qui enjambe l'élément actif (12) et le diaphragme (21), étant disposé au-dessus du diaphragme (21, 41), vu dans la direction de rayonnement de lumière (R),
et le diaphragme (21) étant conçu comme une feuille ou imprimé et/ou déposé en phase vapeur et/ou pulvérisé
sur l'élément de découplage de lumière (23),
**caractérisé en ce**
**que** l'élément de découplage de lumière (23) comprend une microstructure sous forme de structure de micro-prismes ou de microlentilles.

2. Module d'éclairage selon la revendication 1,
**caractérisé en ce**
**que** l'élément de support (22) est formé d'un matériau transparent et que le diaphragme (21, 41) est disposé sur le côté de l'élément de support (22) opposé à celui de l'élément actif (12).

3. Module d'éclairage selon l'une quelconque des revendications précédentes,
**caractérisé en ce**
**qu'**un élément d'espacement (31) transparent, en particulier une plaque de verre, est disposé entre le diaphragme (21, 41) et l'élément de découplage de lumière (23).

4. Module d'éclairage selon l'une quelconque des revendications précédentes,
**caractérisé en ce,**
**que** le diaphragme (21, 41) est adapté à l'aspect de l'élément actif (12) à l'état éteint, en particulier qu'il présente une couleur correspondant essentiellement à celle de l'élément actif (12).

5. Module d'éclairage selon l'une quelconque des revendications précédentes,
**caractérisé en ce,**
**que** le diaphragme (41) est formé comme une couche réfléchissante.

6. Module d'éclairage selon la revendication 5,
**caractérisé en ce**
**qu'**une feuille polarisant circulairement (42) est disposée au-dessus du diaphragme (41), vu dans la direction de rayonnement de lumière (R), sur le côté faisant face au diaphragme (41) de laquelle est disposée une couche de retardement de quart d'onde.

7. Module d'éclairage selon la revendication 6,
**caractérisé en ce**
**qu'**un élément d'espacement (311) transparent, en particulier une plaque de verre, est disposée entre le diaphragme (41) et la feuille polarisant circulairement (42).

8. Module d'éclairage, comprenant
un élément actif (12) en forme de plaque,
un élément de support (22) en forme de plaque, comprenant une surface (221) sur laquelle est disposé l'élément actif (12), l'élément de support (22) comprenant une zone de bordure (222) en saillie par rapport à l'élément actif (12),
le module d'éclairage comprenant un élément d'homogénéisation (51)
enjambant l'élément actif (12) ainsi que la zone de bordure (222),
**caractérisé en ce**
**que** l'élément d'homogénéisation (51) est formé par une feuille de polarisation réfléchissante,
une feuille de diffusion de lumière ou une feuille de micro-optique étant disposée sur la face supérieure, vu dans la direction du rayonnement de lumière (R), de l'élément d'homogénéisation (51).

9. Module d'éclairage selon la revendication 8,
**caractérisé en ce**
**que** l'élément de support (22) est transparent et qu'un élément de découplage, lequel présente de préférence une microstructure, en particulier une structure de micro-prismes, est disposé entre l'élément de support (22) et l'élément d'homogénéisation (51).

10. Module d'éclairage selon l'une quelconque des revendications précédentes,
**caractérisé en ce**
**que** l'élément actif (12) est formé par une structure OLED ou QLED.
